# EUROPÄISCHE PATENTSCHRIFT

(11) **EP 3 345 466 B1**
(45) Veröffentlichungstag und Bekanntmachung des Hinweises auf die Patenterteilung: **30.09.2020**
(21) Anmeldenummer: 16757241.1
(22) Anmeldetag: 25.08.2016
(51) Int. Cl.: H05K 5/00, H05K 5/06, H05K 9/00

(54) **GEHÄUSEDICHTUNGSANORDNUNG**
HOUSING SEALING ARRANGEMENT
SYSTÈME D'ÉTANCHÉITÉ DE BOÎTIER

(30) Priorität: 04.09.2015 DE 102015114813
(43) Veröffentlichungstag der Anmeldung: 11.07.2018
(73) Patentinhaber: Amphenol-Tuchel Electronics GmbH, 74080 Heilbronnn (DE)
(72) Erfinder: SZYMURA, Dawid, 75031 Eppingen-Richen (DE)
(74) Vertreter: Staeger & Sperling Partnerschaftsgesellschaft mbB
(86) Internationale Anmeldenummer: PCT/EP2016/070125
(87) Internationale Veröffentlichungsnummer: WO 2017/036930

(56) Entgegenhaltungen:
- DE-A1- 10 351 710
- DE-A1-102009 054 758
- DE-A1-102013 102 283
- DE-A1-102013 212 301
- GB-A- 2 236 215
- US-A1- 2001 040 037
- US-A1- 2003 173 100
- US-A1- 2004 190 244

## Beschreibung

Die vorliegende Erfindung betrifft eine Gehäusedichtungsanordnung, insbesondere eine Gehäusedichtungsanordnung für eine Fahrzeuganwendung.

Dichtungen und Dichtungsanordnungen für Gehäuse sind im Stand der Technik umfangreich bekannt. Dichtungen zeigen unterschiedliche Eigenschaften betreffend ihrer Funktion und ihrer Eigenschaften. So sind aus den Druckschriften GB 2 236 215 A, US 2003/0173100 A1 und der DE 103 51 710 A1 bereits Lösungen bekannt, um Gehäuse gegen Umwelteinflüsse abzudichten.

In Fahrzeuganwendungen weisen Gehäuse, insbesondere Gehäuse von Steckverbindungen oder elektrischen Geräten neben einer Dichtungsfunktion gegen Umwelteinflüsse auch weitere technische Funktionen auf. So sind insbesondere bei der Verwendung von metallischen Gehäusen in Elektrofahrzeugen an Leitungssträngen auch Aufgaben gegen elektromagnetische Strahlung zu erfüllen.

Hierzu gibt es insbesondere die von dem Europäischen Parlament herausgegebene Richtlinie zur elektromagnetischen Verträglichkeit (EMV-Richtlinie). Die elektromagnetische Verträglichkeit (kurz: EMV-Eigenschaften) von elektrisch betriebenen Geräten im Europäischen Binnenmarkt wird darin beschrieben. Unter elektromagnetischer Verträglichkeit ist hierbei die Fähigkeit eines Betriebsmittels zu verstehen, in seiner elektromagnetischen Umgebung zufriedenstellend zu arbeiten, ohne dabei selbst elektromagnetische Störungen zu verursachen, die für andere Betriebsmittel in der selben Umgebung wiederum unannehmbar bzw. störend wären. Somit ist unter elektromagnetischer Störung jede elektromagnetische Erscheinung zu verstehen, die die bestimmungsgemäße Funktion eines Betriebsmittels beeinträchtigen könnte.

Zur Vermeidung einer solchen elektromagnetischen Störung ist ein angemessenes EMV-Niveau der elektromagnetischen Verträglichkeit für jedes Betriebsmittel festzulegen. Die EMV-Richtlinie nennt hierzu jedoch keine einzuhaltenden prinzipiellen Grenzwerte. Vielmehr ist festgelegt, dass die von einem Betriebsmittel verursachten elektromagnetischen Störungen einen applikationsspezifischen Pegel nicht übersteigen dürfen.

Aufgabe der vorliegenden Erfindung ist es daher, eine Gehäusedichtungsanordnung bereitzusehen, bei der ein Gehäuseteil mit einem korrespondierenden Gehäuseteil - zusammengebracht werden soll und einerseits die Gehäuseteile eine Dichtung gegen Umwelteinflüsse bereitzustellen.

Andererseits soll das Gehäuse seine EMV-Eigenschaften beibehalten, was durch eine insbesondere elektrisch nicht leitfähige Dichtung nicht gewährleistet ist.

Eine weitere Aufgabe der vorliegenden Erfindung ist es, auf engstem Bauraum eine entsprechende Lösung bereitzustellen, bei der einerseits eine Schirmübertragung und andererseits eine Dichtung gegenüber Medien ermöglicht wird. Ferner ist es Aufgabe der vorliegenden Erfindung sicherzustellen, dass Schirmübergabeelemente nicht durch Umwelteinflüsse wie Flüssigkeit und der gleichen Korrosionserscheinungen unterliegen.

Diese Aufgabe wird mit einer Gehäusedichtungsanordnung gemäß den Merkmalen von Anspruch 1 gelöst.

Grundgedanke der vorliegenden Erfindung besteht darin, eine mehrstufige bzw. abgestufte Nut auf der Stirnseite eines Gehäuses vorzusehen, die bestimmungsgemäß als Dichtungsstirnseite ausgebildet ist und gegen ein korrespondierendes Gehäuse abdichten soll.

Mit Vorteil wird daher eine wenigstens zweistufig abgestufte Nut entlang einer Dichtkontur auf der Dichtungsstirnseite des Gehäuses eingebracht. Eine erste Stufe bildet eine Auflagefläche für ein erstes Dichtungselement aus, vorzugsweise für eine Umweltdichtung und die zweite oder eine zweite tiefer angeordnete Stufe stellt eine Auflagefläche für ein zweites Dichtelement, vorzugsweise eine EMV-Dichtung bereit.

Erfindungsgemäß ist demnach eine Gehäusedichtungsanordnung für eine Fahrzeuganwendung, insbesondere für Elektrofahrzeuge vorgeschlagen, umfassend ein Gehäuse mit einer zur Dichtung mit einer zum Gegengehäuse vorgesehenen Dichtungsstirnseite, wobei im Gehäuse entlang der Dichtungsstirnseite eine abgestufte Nut vorgesehen ist, welche wenigstens eine erste Stufe als Auflagefläche für ein erstes Dichtelement und eine zweite (tiefere) Stufe als Auflagefläche für ein zweites Funktionselement, vorzugsweise ein Schirmübergabeelement oder ein zweites Dichtungselement aufweist.

Weiter bevorzugt stettt das zweite Dichtelement gleichzeitig ein Schirmübergabeelement dar.

In einer bevorzugten Ausführungsform der Erfindung ist vorgesehen, dass die Auflagefläche der ersten Stufe gegenüber der Dichtungsstirnseite des Gehäuses und zwar in Richtung des Gehäuseinneren zurückgesetzt ist.

Anders ausgedrückt bedeutet dies, dass gegenüber der Dichtungsstirnseite die Nut mit einer ersten zurückliegenden Stufe ausgebildet ist, auf welche ein erstes Dichtungselement aufgebracht werden kann.

In einer weiter bevorzugten Ausführungsform der Erfindung ist vorgesehen, dass die Auflagefläche der zweiten Stufe ebenfalls gegenüber der Dichtungsstirnseite des Gehäuses in Richtung des Gehäuseinneren zurückgesetzt ist.

In einer besonders vorteilhaften Ausführungsform der Erfindung ist ferner vorgesehen, dass die Auflagefläche der zweiten Stufe auch gegenüber der Auflageflächen der ersten Stufe tiefer, und zwar in Richtung des Gehäuseinneren des Gehäuses zurückgesetzt ist.

Anders ausgedrückt bedeutet dies, dass beginnend von der Dichtungsstirnseite eine erste Stufe auf die Auflagefläche für ein erstes Dichtungselement und von dieser Auflagefläche eine zweite Stufe auf die Auflagefläche für ein zweites Dichtungselement führt.

Es ist weiter mit Vorteil vorgesehen, dass auf der Auflagefläche der ersten Stufe ein erstes Dichtelement angeordnet ist.

Weiter bevorzugt ist es, wenn auf der Auflagefläche der zweiten Stufe ein Funktionselement, vorzugsweise ein zweites Dichtelement mit einer weiteren Funktion angeordnet ist.

Erfindungsgemäß ist mit Vorteil vorgesehen, dass die dichtenden Stirnseiten der ersten und zweiten Dichtung jeweils gegenüber der Gehäusestirnseite aus dieser bzw. aus der Nut hervorstehen und über diese Stirnseite hinausragen.

Es ist weiter mit Vorteil vorgesehen, wenn die erste und zweite Dichtung in einer speziellen Querschnittsgröße zueinander ausgebildet sind. So ist es mit Vorteil vorgesehen, wenn der Querschnitt der ersten Dichtung in etwa 20 % bis 30 %, weiter bevorzugt etwa 22 % bis 26 % des Querschnittes der zweiten Dichtung aufweist.

In einer weiter vorteilhaften Ausgestaltung der Erfindung wird ferner vorgesehen, dass zwischen dem ersten (kleineren) und dem zweiten (größeren) Dichtelement ein Abstand von wenigstens der Breite (in Abstandsrichtung betrachtet) des ersten Dichtelementes vorgesehen ist.

Durch die zuvor genannten Maßnahmen kann dadurch sichergestellt werden, dass einerseits ein ausreichender Spalt zwischen den beiden Funktionselementen, sprich Dichtelementen vorgesehen ist und andererseits die Pressung der jeweiligen Dichtung den gewünschten funktionalen und strukturellen Anforderungen genügt.

Hierzu kann vorgesehen sein, dass beide Dichtungen als Elastomere ausgebildet sind, wobei die Umweltdichtung bevorzugt als ein aufgeschäumter Silikonwerkstoff ausgebildet ist, während die EMV-Dichtung ein Elastomer mit einem Additiv, insbesondere einem Aluminiumpulver ausgebildet wird. Andere leitfähige Pulver, die insbesondere hoch korrosionsbeständigen Pulver, können in alternativen Ausführungsformen vorgesehen werden.

Es ist weiter mit Vorteil vorgesehen, dass die beiden Dichtelemente um die Gehäuseöffnung entlang einer gemeinsamen unterbrechungsfreien Nut (einer Dichtkontur) umlaufend in die Dichtungsstirnseite des Gehäuses eingebracht sind, wobei das erste Dichtelement als inneres, d. h. innen liegendes Dichtelement ausgebildet ist, während das zweite Dichtelement als äußeres, d. h. außen liegendes, um das erste Dichtelement herum angeordnetes Dichtelement vorgesehen ist. Anders ausgedrückt bedeutet dies, dass das erste Dichtelement als inneres gegenüber dem zweiten Dichtelement zur Gehäuseöffnung hin näher angeordnetes Dichtelement vorgesehen ist.

In einer weiter bevorzugten Ausführungsform der vorliegenden Erfindung ist vorgesehen, dass das erste Dichtelement als eine Umweltdichtung ausgebildet ist und das zweite Dichtelement als eine EMV-Dichtung ausgebildet ist.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher erläutert. Die Figuren zeigen:
- Fig. 1: eine perspektivische Ansicht einer Gehäusedichtungsanordnung eines Gehäuses;
- Fig. 2: eine Schnittanstcht durch die Gehäusedichtungsanordnung gemäß Fig. 1;
- Fig. 3: eine Detailansicht des Details C aus Fig. 2.

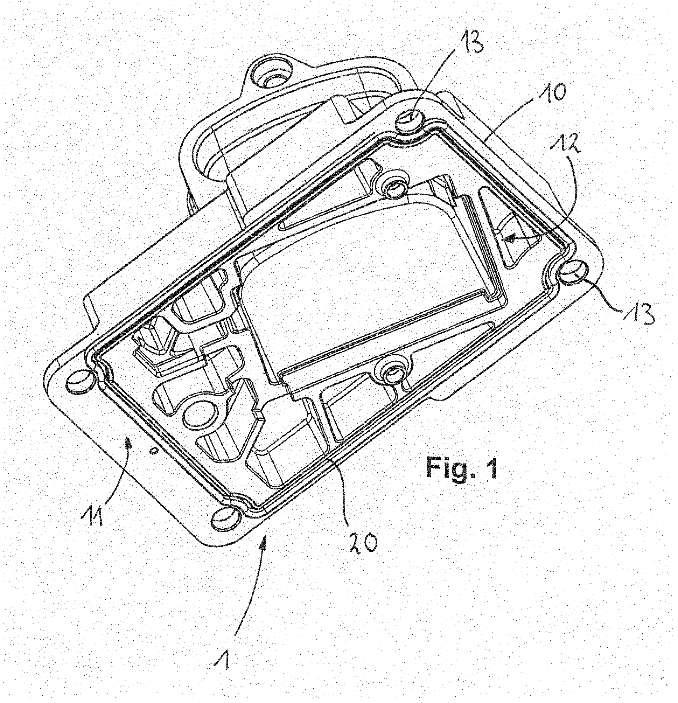

Die Erfindung wird im Folgenden anhand eines Ausführungsbeispieles mit Bezug auf die Fig. 1 bis Fig. 3 näher erläutert. Gleiche Bezugszeichen weisen auf gleiche funktionale und/oder strukturelle Merkmale hin.

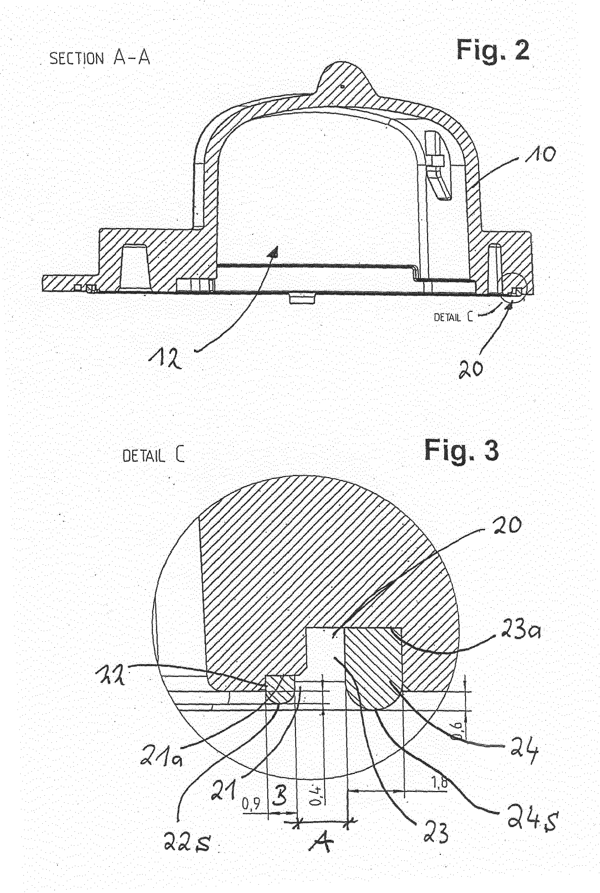

In den Fig. 1 bis Fig. 3 wird ein Ausführungsbeispiel einer Gehäusedichtungsanordnung 1 gezeigt. Die Gehäusedichtungsanordnung 1 umfasst ein Gehäuse 10, welches mit einer zur Dichtung mit einem nicht gezeigten Gegengehäuse, vorgesehen einer Dichtungsstirnseite 11 ausgebildet ist. Im Gehäuse 10 ist entlang der Dichtungsstirnseite 11 eine zweifach abgestufte Nut 20 vorgesehen mit einer ersten Stufe 21 und einer zweiten tiefer angeordneten Stufe 23. Die erste Stufe 21 bildet eine Auflagefläche 21a für ein wie in Fig. 3 gezeigtes erstes Dichtelement 22 aus, während die zweite (tiefere) Stufe 23 eine Auflagefläche 23a für ein zweites Dichtelement 24 ausbildet.

Wie ferner zu erkennen, läuft die Nut 20 entlang einer Dichtungskontur umlaufend um die Gehäuseöffnung 12 herum, um das Gehäuseinnere abzudichten. An den Ecken des Gehäuses 10 befinden sich Befestigungsöffnungen 13.

Die Schnittansicht gemäß Fig. 2 und das Detail gemäß Fig. 3 zeigen die erfindungsgemäß zweifach abgestufte Nut 20.

Wie zu erkennen ist, ist die Auflagefläche 21a der ersten Stufe 21 gegenüber der Dichtungsstirnseite 11 des Gehäuses 10 in Richtung des Gehäuseinneren (in den Fig. 2 und Fig. 3 nach oben) zurückgesetzt.

Es ist ferner zu erkennen, dass auch die Auflagefläche 23a der zweiten Stufe 23 gegenüber der Dichtungsstirnseite 11 des Gehäuses 10 in Richtung des Gehäuseinneren zurückgesetzt ist.

Die Auflagefläche 23a der zweiten Stufe 23 ist ferner gegenüber der Auflagefläche 21a der ersten Stufe 21 tiefer angeordnet, d. h. in Richtung des Gehäuseinneren des Gehäuses 10 weiter zurückgesetzt. Hierdurch ergibt sich die abgestufte Form der Nut 20.

Wie weiter in den Fig. 2 und Fig. 3 zu erkennen ist, ist auf der Auflagefläche 21a der ersten Stufe 21 ein erstes Dichtelement 22 und auf der Auflagefläche 23a der zweiten Stufe 23 ein zweites Dichtelement 24 angeordnet. Beide Stirnseiten 22s, 24s der beiden Dichtelemente 22, 24 aus dem Gehäuse 10 und zwar gegenüber der Dichtungsstirnseite 11 hervorstehen.

Wie ferner zu erkennen ist, steht die Dichtungsstirnseite 24s des Dichtungselementes 24 gegenüber der Stirnseite 22s des ersten Dichtelementes 22 ein Stück weiter aus dem Gehäuse 10 hervor.

Es ist weiter bei der vorliegenden Ausführungsform vorgesehen, dass der Querschnitt der ersten Dichtung 22 in etwa 25 % des Querschnittes der zweiten Dichtung 24 beträgt.

In Fig. 3 ist deutlich zu erkennen, dass zwischen dem ersten und dem zweiten Dichtelement 22 bzw. 24 ein bestimmungsgemäßer Abstand A von wenigstens der Breite B des ersten Dichtelementes 22 vorgesehen ist. Durch den räumlichen Abstand und ferner durch die unterschiedlich verwendeten Materialien für Umweltdichtung und EMV-Dichtung wird verhindert, dass die innen liegende EMV-Dichtung 24 korrosiven Eigenschaften ausgesetzt wird. Insofern bildet das erste Dichtelement 22 sowie der "Graben" zwischen dem ersten Dichtelement 22 und dem EMV-Dichtelement 24 eine bestimmungsgemäße Doppelbarriere, um Korrosion und Umwelteinflüsse von dem EMV-Dichtelement 24 fernzuhalten und damit vom Inneren des Gehäuses 10.

Wie weiter zu erkennen ist, sind die beiden Dichtelemente 22, 24 um die Gehäuseöffnung 12 entlang einer gemeinsamen unterbrechungsfreien Nut 20 umlaufend in die Dichtungsstirnseite 11 eingebracht, wobei das zweite Dichtelement 24 als inneres, gegenüber dem ersten Dichtelement 22 zur Gehäuseöffnung 12 hin näher angeordnetes Dichtelement vorgesehen ist. Hierdurch schützt das äußere erste Dichtelement 22 vollständig das zweite innere Dichtelement 24.

Die Erfindung beschränkt sich in ihrer Ausführung nicht auf die vorstehend angegebenen bevorzugten Ausführungsbeispiele. Vielmehr sind eine Anzahl von Varianten, Ausführungsarten, welche von der dargestellten Lösung und der dargestellten Konstruktion auch bei grundsätzlich anders gearteten Ausführungen Gebrauch macht, denkbar.

### Bezugszeichenliste

- 1: Gehäusedichtungsanordnung

- 10: Gehäuse
- 11: Dichtungsstirnseite
- 12: Gehäuseöffnung
- 13: Befestigungsöffnung

- 20: Nut
- 21: erste Stufe
- 21a: Auflagefläche
- 22: erstes Dichtelement
- 22s: Stirnseite
- 23: zweite Stufe
- 23a: Auflagefläche
- 24: zweites Dichtelement
- 24s: Stirnseite

- A: Abstand
- B: Breite

## Patentansprüche

1. Gehäusedichtungsanordnung (1) für eine Fahrzeuganwendung, insbesondere für Elektrofahrzeuge umfassend ein Gehäuse (10) mit einer zur Dichtung mit einem Gegengehäuse vorgesehener Dichtungsstirnseite (11), **dadurch gekennzeichnet, dass** im Gehäuse (10) entlang der Dichtungsstirnseite (11) eine abgestufte Nut (20) vorgesehen ist, welche wenigstens eine erste Stufe (21) als Auflagefläche (21a) für ein erstes Dichtelement (22) und eine zweite (tiefere) Stufe (23) als Auflagefläche (23a) für ein zweites Dichtelement (24) ausgebildet ist.

2. Gehäusedichtungsanordnung (1) gemäß Anspruch 1, **dadurch gekennzeichnet, dass** die Auflagefläche (21a) der ersten Stufe (21) gegenüber der Dichtungsstirnseite (11) des Gehäuses (10) in Richtung des Gehäuseinneren zurückgesetzt ist.

3. Gehäusedichtungsanordnung (1) gemäß Anspruch 1 oder 2, **dadurch gekennzeichnet, dass** die Auflagefläche (23a) der zweiten Stufe (23) gegenüber der Dichtungsstirnseite (11) des Gehäuses (10) in Richtung des Gehäuseinneren zurückgesetzt ist.

4. Gehäusedichtungsanordnung (1) gemäß einem der vorhergehenden Ansprüche, **dadurch gekennzeichnet, dass** die Auflagefläche (23a) der zweiten Stufe (23) gegenüber der Auflagefläche (21a) der ersten Stufe (21) tiefer in Richtung des Gehäuseinneren des Gehäuses (10) zurückgesetzt ist.

5. Gehäusedichtungsanordnung (1) gemäß einem der vorhergehenden Ansprüche, **dadurch gekennzeichnet, dass** auf der Auflagefläche (21a) der ersten Stufe (21) ein erstes Dichtelement (22) angeordnet ist.

6. Gehäusedichtungsanordnung (1) gemäß einem der vorhergehenden Ansprüche, **dadurch gekennzeichnet, dass** auf der Auflagefläche (23a) der zweiten Stufe (23) ein zweites Dichtelement (24) angeordnet ist.

7. Gehäusedichtungsanordnung (1) gemäß einem der vorhergehenden Ansprüche 5 oder 6, **dadurch gekennzeichnet, dass** die dichtende Stirnseiten (22s, 24s) der Dichtelemente (22 und 24) aus dem Gehäuse (10) hervorsteht.

8. Gehäusedichtungsanordnung (1) gemäß einem der vorhergehenden Ansprüche 5 bis 7, **dadurch gekennzeichnet, dass** der Querschnitt der ersten Dichtung (22) in etwa 20 % bis 30 % des Querschnittes der zweiten Dichtung (24) aufweist.

9. Gehäusedichtungsanordnung (1) gemäß einem der vorhergehenden Ansprüche 5 bis 8, **dadurch gekennzeichnet, dass** zwischen dem ersten und zweiten Dichtelement (22 bzw. 24) ein Abstand (A) von wenigstens der Breite (B) des ersten Dichtelements (22) vorgesehen ist.

10. Gehäusedichtungsanordnung (1) gemäß einem der vorhergehenden Ansprüche 5 bis 9, **dadurch gekennzeichnet, dass** die beiden Dichtelemente (22 und 24) um die Gehäuseöffnung (12) entlang einer gemeinsamen unterbrechungsfreien Nut (20) umlaufend in die Dichtungsstirnseite (11) eingebracht sind, wobei das zweite Dichtelement (24) als äußeres gegenüber dem ersten Dichtelement (22) zur Gehäuseöffnung (12) hin weiter entfernt angeordnetes Dichtelement vorgesehen ist.

11. Gehäusedichtungsanordnung (1) gemäß einem der vorhergehenden Ansprüche 5 bis 10, **dadurch gekennzeichnet, dass** das erste Dichtelement (22) eine Umweltdichtung und die zweite Dichtung (24) eine EMV-Dichtung darstellt.

## Claims

1. Housing sealing arrangement (1) for a vehicle application, in particular for electrical vehicles, comprising a housing (10) having a sealing end face (11) which is provided for producing a seal with a mating housing, **characterized in that** a stepped groove (20) is provided in the housing (10) along the sealing end face (11), said stepped groove having at least one first step (21) as a support surface (21a) for a first sealing element (22) and a second (lower) step (23) as a support surface (23a) for a second sealing element (24).

2. Housing sealing arrangement (1) according to Claim 1, **characterized in that** the support surface (21a) of the first step (21) is set back in relation to the sealing end face (11) of the housing (10) in the direction of the housing interior.

3. Housing sealing arrangement (1) according to Claim 1 or 2, **characterized in that** the support surface (23a) of the second step (23) is set back in relation to the sealing end face (11) of the housing (10) in the direction of the housing interior.

4. Housing sealing arrangement (1) according to one of the preceding claims, **characterized in that** the support surface (23a) of the second step (23) is set back deeper in the direction of the housing interior of the housing (10) in relation to the support surface (21a) of the first step (21).

5. Housing sealing arrangement (1) according to one of the preceding claims, **characterized in that** a first sealing element (22) is arranged on the support surface (21a) of the first step (21).

6. Housing sealing arrangement (1) according to one of the preceding claims, **characterized in that** a second sealing element (24) is arranged on the support surface (23a) of the second step (23).

7. Housing sealing arrangement (1) according to either of the preceding Claims 5 and 6, **characterized in that** the sealing end faces (22s, 24s) of the sealing elements (22 and 24) protrude out of the housing (10).

8. Housing sealing arrangement (1) according to one of the preceding Claims 5 to 7, **characterized in that** the cross section of the first seal (22) has approximately 20% to 30% of the cross section of the second seal (24).

9. Housing sealing arrangement (1) according to one of the preceding Claims 5 to 8, **characterized in that** a distance (A) of at least the width (B) of the first sealing element (22) is provided between the first and second sealing element (22 and 24, respectively).

10. Housing sealing arrangement (1) according to one of the preceding Claims 5 to 9, **characterized in that** the two sealing elements (22 and 24) are introduced into the sealing end face (11) in a manner encircling the housing opening (12) along a common, interruption-free groove (20), wherein the second sealing element (24) is provided as an outer sealing element which is arranged further away from the first sealing element (22) towards the housing opening (12).

11. Housing sealing arrangement (1) according to one of the preceding Claims 5 to 10, **characterized in that** the first sealing element (22) is an environmental seal and the second seal (24) is an EMC seal.

## Revendications

1. Ensemble de joint d'étanchéité de boîtier (1) pour une application automobile, en particulier pour des véhicules électriques, comprenant un boîtier (10) ayant une face frontale de joint (11) prévue pour l'étanchéité avec un boîtier complémentaire, **caractérisé en ce que** dans le boîtier (10), le long de la face frontale de joint (11), une rainure étagée (20) est prévue qui est réalisée avec au moins un premier gradin (21) comme une surface d'appui (21a) pour un premier élément d'étanchéité (22) et un deuxième gradin (23) (plus bas) comme une surface d'appui (23a) pour un deuxième élément d'étanchéité (24).

2. Ensemble de joint d'étanchéité de boîtier (1) selon la revendication 1, **caractérisé en ce que** la surface d'appui (21a) du premier gradin (21) est en mise en retrait par rapport à la face frontale de joint (11) du boîtier (10) vers l'intérieur de boîtier.

3. Ensemble de joint d'étanchéité de boîtier (1) selon la revendication 1 ou 2, **caractérisé en ce que** la surface d'appui (23a) du deuxième gradin (23) est mise en retrait par rapport à la face frontale de joint (11) du boîtier (10) vers l'intérieur de boîtier.

4. Ensemble de joint d'étanchéité de boîtier (1) selon l'une quelconque des revendications précédentes, **caractérisé en ce que** la surface d'appui (23a) du deuxième gradin (23) est mise en retrait par rapport à la surface d'appui (21a) du premier gradin (21) plus bas vers l'intérieur de boîtier du boîtier (10).

5. Ensemble de joint d'étanchéité de boîtier (1) selon l'une quelconque des revendications précédentes, **caractérisé en ce qu'**un premier élément d'étanchéité (22) est disposé sur la surface d'appui (21a) du premier gradin (21).

6. Ensemble de joint d'étanchéité de boîtier (1) selon l'une quelconque des revendications précédentes, **caractérisé en ce qu'**un deuxième élément d'étanchéité (24) est disposé sur la surface d'appui (23a) du deuxième gradin (23).

7. Ensemble de joint d'étanchéité de boîtier (1) selon l'une quelconque des revendications précédentes 5 et 6, **caractérisé en ce que** les faces frontales (22s, 24s), créant l'étanchéité, des éléments d'étanchéité (22 et 24) font saillie du boîtier (10).

8. Ensemble de joint d'étanchéité de boîtier (1) selon l'une quelconque des revendications précédentes 5 à 7, **caractérisé en ce que** la section transversale du premier joint (22) présente approximativement 20 % à 30 % de la section transversale du deuxième joint (24).

9. Ensemble de joint d'étanchéité de boîtier (1) selon l'une quelconque des revendications précédentes 5 à 8, **caractérisé en ce qu'**une distance (A) égale à au moins la largeur (B) du premier élément d'étanchéité (22) est prévue entre le premier et le deuxième élément d'étanchéité (22 ou 24).

10. Ensemble de joint d'étanchéité de boîtier (1) selon l'une quelconque des revendications précédentes 5 à 9, **caractérisé en ce que** les deux éléments d'étanchéité (22 et 24) sont insérés dans la face frontale de joint (11) de manière périphérique autour de l'ouverture de boîtier (12) le long d'une rainure continue (20) commune, le deuxième élément d'étanchéité (24) étant prévu comme un élément d'étanchéité extérieur, disposé plus loin vers l'ouverture de boîtier (12) par rapport au premier élément d'étanchéité (22).

11. Ensemble de joint d'étanchéité de boîtier (1) selon l'une quelconque des revendications précédentes 5 à 10, **caractérisé en ce que** le premier élément d'étanchéité (22) est un joint environnemental et le deuxième joint (24) est un joint CEM.
